# EUROPEAN PATENT APPLICATION

(11) **EP 4 156 050 A1**
(43) Date of publication of application: **29.03.2023**
(21) Application number: 21199422.3
(22) Date of filing: 28.09.2021
(51) Int. Cl.: G06Q 10/06

(54) **METHOD AND SYSTEM FOR OPTIMIZING AN ENGINEERING PROJECT IN A TECHNICAL INSTALLATION**

(71) Applicant: Siemens Aktiengesellschaft, 80333 München (DE)
(72) Inventor: Antony, Elvis, 560102 Bangalore, Karnataka (IN); Oruganti, Srivathsa Simha, 560100 Bangalore, Karnataka (IN)
(74) Representative: Isarpatent

(57) **Abstract**

The present invention provides a method and system for optimizing an engineering project (106B) in a technical installation (106A). The method comprises receiving a request to optimize an engineering project (106B) in a technical installation. The request comprises a piping and instrumentation diagram (506) of the engineering project (106B). The method further comprises generating an ontology schema. The method further comprises displaying on a wearable device the determined plurality of industrial processes associated with the engineering project (106B) and the plurality of key process indicators associated with each of the plurality of industrial processes. The method further comprises optimizing the engineering project (106B) by modifying one or more engineering objects 108A-N of the engineering project (106B), such that the at least one key process indicator of the at least one industrial process of the plurality of industrial processes is optimized.

## Description

The present invention relates to a field of computer assisted programming, and more particularly relates to a method and system for optimizing an engineering project in a technical installation.

Typically, an engineering project comprises a plurality of engineering objects. Each of the plurality of engineering objects comprises information and source code associated with a specific industrial process in a plurality of industrial processes of the engineering project. Examples of the plurality of engineering objects comprises a design file, a program file, an openness file, an automation markup language (AML) file, a memory object, a description of a physical engineering equipment, and and a piping and instrumentation diagram of a technical installation. The plurality of industrial processes comprises chemical, biological, and thermodynamic processes occurring in the technical installation.

Each of the plurality of engineering objects may have a different specification of a plurality of specifications. A specification of an engineering object defines a purpose of the engineering object. The specification comprises coding languages, coding conventions, hardware configuration, software configurations, processing speed restrictions, memory restrictions, and key process indicators associated with the engineering object.

In one example, a first engineering object is a program file which is configured to control a first industrial process of the plurality of industrial processes. To enable the first engineering object to control the first industrial process, a code developer has to manually code the first engineering object. Further, in order to optimize the first industrial process, the code developer has to manually tweak the first industrial process.

Further, since the plurality of engineering objects are sometimes co-dependent on each other, the code developer may have to manually modify each of the plurality of engineering objects of the engineering project, to optimize the first industrial process. Thus, the code developer may have to modify several thousand lines of code for optimizing a specific industrial process of the plurality of industrial processes. Thus, it becomes very difficult and time consuming to optimize the engineering project.

Further, each of the plurality of engineering objects comprises a large number of data items and meta data items. The plurality of data items comprises code statements, data variables, variable assignment statements, design features, graphical interface layout, blueprints, configuration settings, looped statements comprised in the plurality of engineering objects. The plurality of metadata items comprises date of creation, author name, domain of an industrial environment in which the engineering project is deployed. Each of the plurality of data items and the plurality of meta data items of a given engineering object may have data and control flow interrelationships with other data items and meta data items of other engineering objects. The code developer may have to strictly maintain interrelationships between the plurality of data items and the plurality of metadata items while optimizing the engineering project. Furthermore, the code developer may find it extremely difficult to optimize the engineering project while maintaining the integrity of the engineering project.

Thus, it is laboursome for the object designer to manually go through the huge number of data items and the huge number of metadata items, as well as identify the interrelationships between the plurality of data items and the plurality of meta data items in the first engineering object.

In light of above, there exists a need for an efficient method and system for optimizing an engineering project in a technical installation.

Therefore, it is an object of the present invention to provide a method and system for optimizing an engineering project in a technical installation.

The object of the invention is achieved by a method for optimizing an engineering project in a technical installation. The method comprises receiving, by a processing unit, a request to optimize an engineering project in a technical installation. The request comprises information about a piping and instrumentation diagram of the engineering project. The request is received from a user as at least one of a gesture based, text based, or voice based input via an input device such as a microphone, a camera or a keyboard. The engineering project comprises a plurality of engineering objects. Each of the plurality of engineering objects comprises information and source code associated with a specific industrial process in a plurality of industrial processes of the engineering project. Examples of the plurality of engineering objects comprises a design file, a program file, an openness file, an automation markup language (AML) file, a memory object, a description of a physical engineering equipment, and a piping and instrumentation diagram of a technical installation. The plurality of industrial processes comprises chemical, biological, and thermodynamic processes occurring in the technical installation.

In the preferred embodiment, the method comprises applying, by the processing unit, a natural language processing algorithm on information comprised in the engineering project. In one example, the engineering project comprises description of a plurality of parameter values, a blueprint, internal components, and internal interconnections between various internal components of the technical installation. The description comprises text-based descriptions, figures, and blueprints of the engineering project.

In the prefered embodiment, the method further comprises determining, by the processing unit, a plurality of data items and a plurality of meta data items associated with the engineering project based on the application of the natural language processing algorithm. Examples of the natural language processing algorithm includes but is not limited to Bayesian network algorithms and conditional random field algorithms. The plurality of data items comprises blueprints, descriptions about internal components of the second physical industrial equipment, code statements, data variables, variable assignment statements, looped statements comprised in the engineering project. The plurality of metadata items comprises date of creation, author name, domain of an industrial environment in which the engineering project is deployed. Each of the plurality of data items and the plurality of meta data items of the engineering project may have data and control flow interrelationships with other data items and meta data items of the engineering project.

In a preferred embodiment, the method further comprises generating, by the processing unit an ontology schema for the engineering project. The ontology schema comprises information about relationships between the piping and instrumentation diagram, and the plurality of engineering objects of the engineering project. The ontology schema further comprises information associated with the interrelationships and dependencies between the plurality of data items and the plurality of metadata items of the engineering project. The ontology schema is a digital twin of the engineering project. In one example, the ontology schema is a knowledge graph based representation. The ontology schema is generated by an analysis of engineering project. Advantageously, all interrelationships between the plurality of data items and the plurality of meta data items associated with the engineering project is captured by the processing unit automatically. Advantageously, a code developer is not required to manually extract and understand the plurality of data items and meta data items from the engineering project, prior to modifying/optimizing the engineering project. Thus, amount of time and labour of the code developer, invested to modify or optimize the engineering project is diminished significantly.

The method comprises determining, by the processing unit, the plurality of industrial processes associated with the engineering project and a plurality of key process indicators associated with each of the plurality of industrial processes, based on an analysis of the ontology schema. The plurality of key process indicators comprises measurement data which indicate a progress of at least one industrial process of the plurality of industrial processes. Examples of the key process indicators comprises a temperature measurement, a pressure measurement and a vibration measurement.

In the preferred embodiment, the method further comprises displaying on a wearable device, by the processing unit, the determined plurality of industrial processes associated with the engineering project and the plurality of key process indicators associated with each of the plurality of industrial processes. The wearable device is at least one of a handheld computing device or an augmented reality capable display device. Advantageously, a user is enabled to visualize the plurality of industrial processes and the plurality of key process indicators in the wearable device.

In the preferred embodiment, the method further comprises receiving, by the processing unit, a user selection of the at least one industrial process of the plurality of industrial processes and the at least one key process indicator of the plurality of key process indicators. The user selection may be received via an input device such as a keyboard, a computer mouse, a microphone, a touchscreen device or a camera. The method further comprises analyzing, by the processing unit, the ontology schema to map the selected at least one industrial process and the selected at least one key process indicator to the one or more engineering objects of the engineering project. The method further comprises determining, by the processing unit, the one or more engineering objects of the plurality of engineering objects, which is required to be modified to optimize the at least one key process indicator of the at least one industrial process based on the analysis of the ontology schema. Advantageously, the one or more engineering objects which are linked to the at least one industrial process and the at least one key process indicator is determined by the processing unit automatically. Advantageously, the code developer is not required to manually identify interdependencies between the plurality of engineering objects and the plurality of industrial processes.

In the preferred embodiment, the method further comprises optimizing, by the processing unit, the engineering project by modifying one or more engineering objects of the engineering project, such that the at least one key process indicator of the at least one industrial process of the plurality of industrial processes is optimized. The one or more engineering objects is one of a program file, an openness file, an automation markup language (AML) file, a memory object, a physical engineering equipment, and piping and instrumentation diagram.

In the preferred embodiment, the method further comprises determining, by the processing unit, a plurality of modifications to be executed on the determined one or more engineering objects, to optimize the at least one key process indicator of the at least one industrial process of the plurality of industrial processes. The modifications comprise any changes such as addition, deletion, update, replacement or revision of one or more variables, code lines, classes, functions, or comments in the one or more engineering objects. The method further comprises optimizing, by the processing unit, the engineering project by modifying the one or more engineering objects of the engineering project based on the determined plurality of modifications.

In the preferred embodiment, the method further comprises receiving, by the processing unit, a plurality of process values associated with the plurality of industrial processes. The plurlaity of process values comprises a temperature value, a pressure value, a vibration value, and the like. The method further comprises determining, by the processing unit, a health level of each of the plurality of industrial processes based on an analysis of the ontology schema and the plurality of process values. The method further comprises determining, by the processing unit, an unhealthy industrial process from the plurality of industrial processes based on the determined health level of each of the plurality of industrial processes. In one example, the health level of the at least one industrial process is determined based on an application of a machine learning algorithm on the plurality of process values. The machine learning algorithm is trained on historical data comprising a plurality of engineering projects and a plurality of industrial processes such that the machine learning algorithm is configured to determine the health level of the at least one industrial process. Advantageously, the health level of the at least one industrial process is determined based on historical data.

In an embodiment, the method further comprises analyzing, by the processing unit, the ontology schema to map the unhealthy industrial process to a set of engineering objects of the engineering project. The method further comprises determining, by the processing unit, that the set of engineering objects of the plurality of engineering objects, is required to be modified to optimize the unhealthy industrial process based on the analysis of the ontology schema. The modifications comprise any changes such as addition, deletion, update, replacement or revision of one or more variables, code lines, classes, functions, or comments in the one or more engineering objects. The method further comprises determining, by the processing unit, a plurality of modifications to be executed on the determined set of engineering objects, to optimize at least one key process indicator of the unhealthy industrial process of the plurality of industrial processes. The method further comprises optimizing, by the processing unit, the engineering project by modifying the set of engineering objects associated with the unhealthy industrial process based on the determined plurality of modifications.

In an embodiment, the method further comprises capturing, by the processing unit, an image of the piping and instrumentation diagram. The image is captured by the processing unit by use of an image capture device such as a camera. In another example, the image may be received by the processing unit from a server or the like. In one example, the method further comprises segmenting, by the processing unit, the captured image of the piping and instrumentation diagram into a plurlaity of portions. Each of the plurality of portions corresponds to at least one industrial process of the plurlaity of industrial processes.

In a preferred embodiment, the method further comprises superposing, by the processing unit, information associated with the plurality of industrial processes associated with the engineering project and the plurality of key process indicators associated with each of the determined plurality of industrial processes, on the captured image of the piping and instrumentation diagram. In one example, a specific industrial process and a specific Key process indicator associated with the specific industrial process is superposed upon a specific portion of the image, which corresponds to the specific industrial process and the specific Key process indicator.

In a preferred embodiment, the method further comprises displaying, by the processing unit, the piping and instrumentation diagram and the information associated with the plurality of industrial processes associated with the engineering project and the plurality of key process indicators associated with each of the determined plurality of industrial processes on an augmented reality based user interface.

In a preferred embodiment, the method further comprises generating, by the processing unit, a simulation instance for an industrial environment. The industrial environment refers to a processing environment comprising configurable computing physical and logical resources, for example, networks, servers, storage, applications, services, etc., and data distributed over a platform, such as cloud computing platform. The method further comprises simulating, by the processing unit, deployment of the optimized engineering project in the industrial environment by executing one or more functionalities of the engineering project on the generated simulation instance.

In a preferred embodiment, the method further comprises determining, by the processing unit, whether the optimized engineering project is valid, based on a result of the simulated execution of the generated engineering project. The method further comprises deploying, by the processing unit, the optimized engineering project in real-time onto the industrial environment, based on a determination that the optimized engineering project is valid. The method further comprises displaying, by the processing unit, the engineering project on a display device.

The object of the present invention is also achieved by an engineering system for optimizing engineering project in the technical installation. The engineering system comprises one or more processing unit(s) and a memory coupled to the processing unit. The memory comprises an automation module stored in the form of machine-readable instructions executable by the processing unit. The automation module is configured for performing the method as described above.

The object of the present invention is also achieved by an industrial environment. The industrial environment comprising an engineering system, a technical installation comprising one or more physical components and one or more client devices communicatively coupled to the engineering system and the technical installation. The engineering system is configured to perform the above described method steps.

The object of the present invention is also achieved by a computer-program product having machine-readable instructions stored therein, that when executed by one or more processing unit(s), cause the one or more processing unit(s) to perform method steps as described above.

The above-mentioned and other features of the invention will now be addressed with reference to the accompanying drawings of the present invention. The illustrated embodiments are intended to illustrate, but not limit the invention.

The present invention is further described hereinafter with reference to illustrated embodiments shown in the accompanying drawings, in which:
- FIG 1: is a block diagram of an industrial environment capable of generating an engineering project in a technical installation, according to an embodiment of the present invention;
- FIG 2: is a block diagram of an engineering system, such as those shown in FIG. 1, in which an embodiment of the present invention can be implemented;
- FIG 3: is a block diagram of an automation module, such as those shown in FIG 2, in which an embodiment of the present invention can be implemented;
- FIG 4A-F: is a process flowchart illustrating an exemplary method of optimizing an engineering project, according to an embodiment of the present invention; and
- FIG 5A-B: is a exemplary illustration of a working of the engineering system, according to an embodiment of the present invention.
Various embodiments are described with reference to the drawings, wherein like reference numerals are used to refer the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

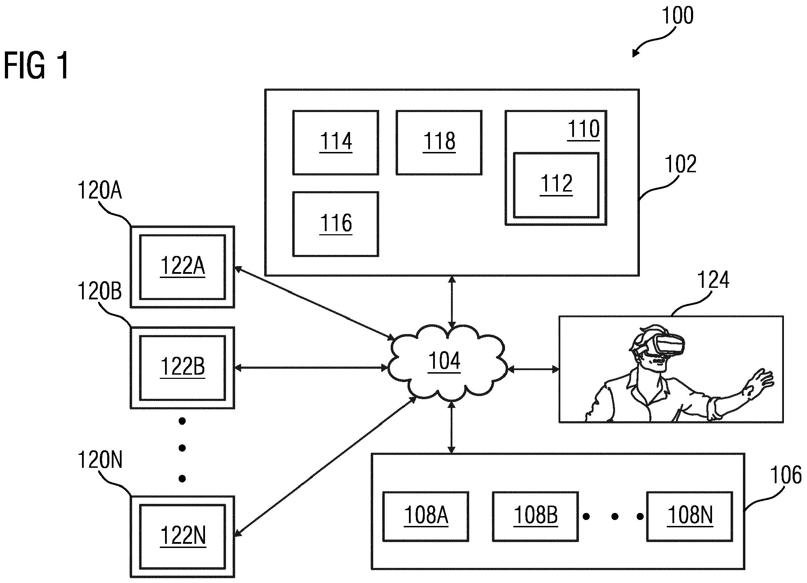

FIG 1 is a block diagram of an industrial environment 100 capable of optimizing an engineering project 106B in a technical installation 106A, according to an embodiment of the present invention. In FIG 1, the industrial environment 100 includes an engineering system 102 controlled with an engineering project 106B and one or more client devices 120A-N. As used herein, "industrial environment" refers to a processing environment comprising configurable computing physical and logical resources, for example, networks, servers, storage, applications, services, etc., and data distributed over a platform, such as cloud computing platform. The industrial environment 100 provides on-demand network access to a shared pool of the configurable computing physical and logical resources. The engineering system 102 is communicatively connected to the engineering project 106B via the network 104 (such as Local Area Network (LAN), Wide Area Network (WAN), Wi-Fi, Internet, any short range or wide range communication). The engineering system 102 is also connected to the one or more client devices 120A-N via the network 104.

The engineering system 102 is controlled with the engineering project 106B which comprises one or more engineering objects 108A-N. Each of the one or more engineering objects 108A-N comprises design information and source code associated with a specific aspect or a specific industrial process of a plurlaity of industrial processes of the engineering project 106B. Examples of the one or more engineering objects 108A-N comprises a design file, a program logic controller block, a tag table, an alarm object, a plant automation object, a program file, an openness file, an automation markup language (AML) file, a memory object, and and a piping and instrumentation diagram of the technical installation 106A. Each of the one or more engineering objects 108A-N may have a different specification of a plurality of specifications. A specification of an engineering object defines a purpose of the engineering object. The specification comprises coding languages, coding conventions, hardware configuration, software configurations, processing speed restrictions, memory restrictions, and key process indicators associated with the engineering object. Each of the one or more engineering objects 108A-N comprises information and source code associated with a specific industrial process in a plurality of industrial processes of the engineering project 106B. The plurality of industrial processes comprises chemical, biological, and thermodynamic processes occurring in the technical installation 106A.

The one or more engineering objects 108A-N may further include source code based representation of a plurality of devices such as servers, robots, switches, automation devices, programmable logic controllers (PLC)s, human machine interfaces (HMIs), motors, valves, pumps, actuators, sensors and other industrial equipment(s). The plurality of devices represented by the one or more engineering objects 108A-N may be connected to each other or several other components (not shown in FIG 1) via physical connections. The physical connections may be through wiring between the plurality of devices. Alternatively, the plurality of devices may also be connected via non-physical connections (such as Internet of Things (IOT)) and 5G networks. Although, FIG 1 illustrates the engineering system 102 connected to the engineering project 106B, one skilled in the art can envision that engineering project 106B may be stored in a memory storage device of the engineering system 102 or be stored in one or more servers located at different geographical locations.

The client devices 120A-N may be a desktop computer, laptop computer, tablet, smart phone and the like. Each of the client devices 120A-N is provided with an engineering tool 122AN for generating and/or editing a plurality of engineering projects respectively. The plurality of engineering projects comprises engineering projects which are designed for controlling the technical installation 106A. Examples of the technical installation includes but is not limited to manufacturing plants, power plants, and recycling plants.

The client devices 120A-N can access the engineering system 102 for automatically generating engineering projects. The client devices 120A-N can access cloud applications (such as providing performance visualization of the one or more engineering objects 108A-N via a web browser). Throughout the specification, the terms "client device" and "user device" are used interchangeably.

The industrial environment 100 further comprises a wearable device 124. wearable device 124may be a heads-up display, a smart watch, a smartphone, laptop computer, tablet, and the like. The wearable device 124 comprises an input device such as a camera, a touchscreen, or a microphone to receive instructions from a user. The wearable device 124 further comprises a display screen. In one example, the wearable device 124 comprises a camera configured to capture images of a piping and instrumentation diagram of the technical installation 106A.

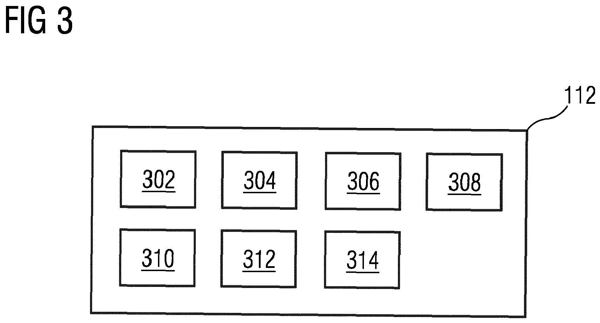

The engineering system 102 may be a standalone server deployed at a control station or may be a remote server on a cloud computing platform. In a preferred embodiment, the engineering system 102 may be a cloud-based engineering system. The engineering system 102 is capable of delivering applications (such as cloud applications) for managing the engineering project 106B comprising the one or more engineering objects 108A-N. The engineering system 102 may comprise a platform 110(such as a cloud computing platform), an automation module 112, a server 114 including hardware resources and an operating system (OS), a network interface 116 and a database 118. The network interface 116 enables communication between the engineering system 102 and the client device(s) 120A-N. The interface (such as cloud interface)(not shown in FIG 1) may allow the engineers at the one or more client device(s) 120A-N to access a plurality of engineering project files stored at the engineering system 102 and perform one or more actions on the plurality of engineering project files as same instance. The server 114 may include one or more servers on which the OS is installed. The servers 114 may comprise one or more processing units, one or more storage devices, such as, memory units, for storing data and machine-readable instructions for example, applications and application programming interfaces (APIs), and other peripherals required for providing computing (such as cloud computing) functionality. The platform 110 enables functionalities such as data reception, data processing, data rendering, data communication, etc. using the hardware resources and the OS of the servers 114 and delivers the aforementioned services using the application programming interfaces deployed therein. The platform 110 may comprise a combination of dedicated hardware and software built on top of the hardware and the OS. In an exemplary embodiment, the platform 110 may correspond to an Integrated Development Environment (IDE) comprising program editors and compilers which allow the users of the client devices 120A-N to generate engineering projects. The platform 110 may further comprise an automation module 112 configured for generating engineering projects. Details of the automation module 112 is explained in FIG. 3.

The database 118 stores the information relating to the engineering project 106B and the client device(s) 120A-N. The database 118 is, for example, a structured query language (SQL) data store or a not only SQL (NoSQL) data store. In an exemplary embodiment, the database 118 may be configured as cloud-based database implemented in the industrial environment 100, where computing resources are delivered as a service over the platform 110. The database 118, according to another embodiment of the present invention, is a location on a file system directly accessible by the automation module 112. The database 118 is configured to store engineering project files, engineering projects, object behavior model, parameter values associated with the one or more engineering objects 108A-N, test results, simulation results, status messages, one or more simulation instances, graphical programs, program logics, program logic patterns, the one or more engineering objects 108A-N and engineering object properties, one or more engineering object blocks, relationship information between the one or more engineering objects 108A-N, requirements, program update messages and the like.

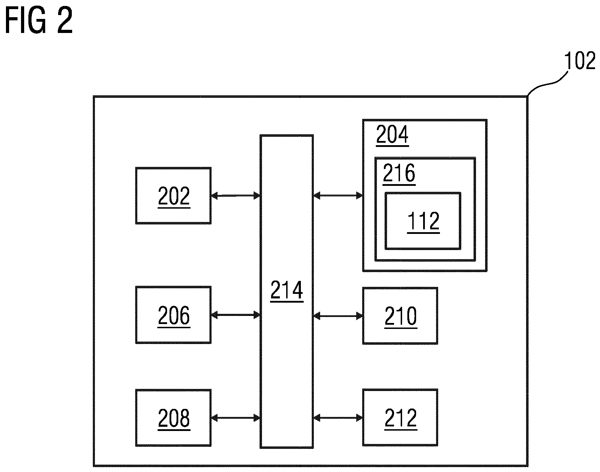

FIG 2 is a block diagram of an engineering system 102, such as those shown in FIG 1, in which an embodiment of the present invention can be implemented. In FIG 2, the engineering system 102 includes a processing unit 202, an accessible memory 204, a storage unit 206, a communication interface 208, an input-output unit 210, a network interface 212 and a bus 214.

The processing unit 202, as used herein, means any type of computational circuit, such as, but not limited to, a micro processing unit unit, microcontroller, complex instruction set computing micro processing unit unit, reduced instruction set computing micro processing unit unit, very long instruction word micro processing unit unit, explicitly parallel instruction computing micro processing unit unit, graphics processing unit, digital signal processing unit, or any other type of processing circuit. The processing unit 202 may also include embedded controllers, such as generic or programmable logic devices or arrays, application specific integrated circuits, single-chip computers, and the like.

The memory 204 may be non-transitory volatile memory and nonvolatile memory. The memory 204 may be coupled for communication with the processing unit 202, such as being a computer-readable storage medium. The processing unit 202 may execute machine-readable instructions and/or source code stored in the memory 204. A variety of machine-readable instructions may be stored in and accessed from the memory 204. The memory 204 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like. In the present embodiment, the memory 204 includes an integrated development environment (IDE) 216. The IDE 216 includes an automation module 112 stored in the form of machine-readable instructions on any of the above-mentioned storage media and may be in communication with and executed by the processing unit 202. In one example, the engineering project 106B may be stored inside the memory 204.

When executed by the processing unit 202, the automation module 112 causes the processing unit 202 to receive a request to optimize the engineering project 106B in a technical installation 106A. The request comprises information about a piping and instrumentation diagram of the engineering project 106B. The request is received from a user as at least one of a gesture based, text based, or voice based input via an input device such as a microphone, a camera or a keyboard. The engineering project 106B comprises a plurality of engineering objects 108A-N. Each of the plurality of engineering objects comprises information and source code associated with a specific industrial process in a plurality of industrial processes of the engineering project 106B. Examples of the plurality of engineering objects comprises a design file, a program file, an openness file, an automation markup language (AML) file, a memory object, a description of a physical engineering equipment, and and a piping and instrumentation diagram of a technical installation. The plurality of industrial processes comprises chemical, biological, and thermodynamic processes occurring in the technical installation 106A.

The automation module 112 further causes the processing unit 202 to apply a natural language processing algorithm on information comprised in the engineering project 106B. In one example, the engineering project 106B comprises description of a plurality of parameter values, a blueprint, internal components, and internal interconnections between various internal components of the technical installation 106A. The description comprises text-based descriptions, figures, and blueprints of the engineering project 106B.

The automation module 112 further causes the processing unit 202 to determine a plurality of data items and a plurality of meta data items associated with the engineering project 106B based on the application of the natural language processing algorithm. Examples of the natural language processing algorithm includes but is not limited to Bayesian network algorithms and conditional random field algorithms. The plurality of data items comprises blueprints, descriptions about internal components of the second physical industrial equipment, code statements, data variables, variable assignment statements, looped statements comprised in the engineering project 106B. The plurality of metadata items comprises date of creation, author name, domain of an industrial environment in which the engineering project 106B is deployed. Each of the plurality of data items and the plurality of meta data items of the engineering project 106B may have data and control flow interrelationships with other data items and meta data items of the engineering project 106B.

The automation module 112 further causes the processing unit 202 to generate an ontology schema for the engineering project 106B. The ontology schema comprises information about relationships between the piping and instrumentation diagram, and the plurality of engineering objectsv 108A-N of the engineering project 106B. The ontology schema further comprises information associated with the interrelationships and dependencies between the plurality of data items and the plurality of metadata items of the engineering project 106B. The ontology schema is a digital twin of the engineering project 106B. In one example, the ontology schema is a knowledge graph based representation. The ontology schema is generated by an analysis of engineering project 106B. Advantageously, all interrelationships between the plurality of data items and the plurality of meta data items associated with the engineering project 106B is captured by the processing unit 202 automatically. Advantageously, a code developer is not required to manually extract and understand the plurality of data items and meta data items from the engineering project 106B, prior to modifying/optimizing the engineering project 106B. Thus, amount of time and labour of the code developer, invested to modify or optimize the engineering project 106B is diminished significantly.

The automation module 112 further causes the processing unit 202 to determine the plurality of industrial processes associated with the engineering project 106B and a plurality of key process indicators associated with each of the plurality of industrial processes, based on an analysis of the ontology schema. The plurality of key process indicators comprises measurement data which indicate a progress of at least one industrial process of the plurality of industrial processes. Examples of the key process indicators comprises a temperature measurement, a pressure measurement and a vibration measurement.

The automation module 112 further causes the processing unit 202 to display on the wearable device 124, the determined plurality of industrial processes associated with the engineering project 106B and the plurality of key process indicators associated with each of the plurality of industrial processes. The wearable device 124 is at least one of a handheld computing device or an augmented reality capable display device. Advantageously, a user is enabled to visualize the plurality of industrial processes and the plurality of key process indicators in the wearable device 124.

The automation module 112 further causes the processing unit 202 to receive a user selection of the at least one industrial process of the plurality of industrial processes and the at least one key process indicator of the plurality of key process indicators. The user selection may be received via an input device such as a keyboard, a computer mouse, a microphone, a touchscreen device or a camera. The automation module 112 further causes the processing unit 202 to analyze the ontology schema to map the selected at least one industrial process and the selected at least one key process indicator to the one or more engineering objects 108A-N of the engineering project 106B. The automation module 112 further causes the processing unit 202 to determine the one or more engineering objects 108A-N of the plurality of engineering objects, which is required to be modified to optimize the at least one key process indicator of the at least one industrial process based on the analysis of the ontology schema. Advantageously, the one or more engineering objects 108A-N which are linked to the at least one industrial process and the at least one key process indicator is determined by the processing unit automatically. Advantageously, the code developer is not required to manually identify interdependencies between the plurality of engineering objects and the plurality of industrial processes.

The automation module 112 further causes the processing unit 202 to optimize the engineering project 106B by modifying one or more engineering objects 108A-N of the engineering projectv 106B, such that the at least one key process indicator of the at least one industrial process of the plurality of industrial processes is optimized. The one or more engineering objects 108A-N is one of a program file, an openness file, an automation markup language (AML) file, a memory object, a physical engineering equipment, and piping and instrumentation diagram.

The automation module 112 further causes the processing unit 202 to determine a plurality of modifications to be executed on the determined one or more engineering objects 108A-N, to optimize the at least one key process indicator of the at least one industrial process of the plurality of industrial processes. The modifications comprise any changes such as addition, deletion, update, replacement or revision of one or more variables, code lines, classes, functions, or comments in the one or more engineering objects 108A-N. The automation module 112 further causes the processing unit 202 to optimize the engineering project 106B by modifying the one or more engineering objects 108A-N of the engineering project 106B based on the determined plurality of modifications.

The automation module 112 further causes the processing unit 202 to receive a plurality of process values associated with the plurality of industrial processes. The plurality of process values comprises a temperature value, a pressure value, a vibration value, and the like. The automation module 112 further causes the processing unit 202 to determine a health level of each of the plurality of industrial processes based on an analysis of the ontology schema and the plurality of process values. The automation module 112 further causes the processing unit 202 to determine a unhealthy industrial process from the plurality of industrial processes based on the determined health level of each of the plurality of industrial processes. In one example, the health level of the plurality of industrial processes is determined based on an application of a machine learning algorithm on the plurality of process values. The machine learning algorithm is trained on historical data comprising a plurality of engineering projects and the plurality of industrial processes such that the machine learning algorithm is configured to determine the health level of the each of the plurality of industrial processes. Advantageously, the health level of the at least one industrial process is determined based on historical data.

The automation module 112 further causes the processing unit 202 to analyze the ontology schema to map the unhealthy industrial process to a set of engineering objects of the engineering project 106B. The automation module 112 further causes the processing unit 202 to determine that the set of engineering objects of the plurality of engineering objects, is required to be modified to optimize the unhealthy industrial process based on the analysis of the ontology schema. The modifications comprise any changes such as addition, deletion, update, replacement or revision of one or more variables, code lines, classes, functions, or comments in the one or more engineering objects 108A-N. The automation module 112 further causes the processing unit 202 to determine a plurality of modifications to be executed on the determined set of engineering objects, to optimize at least one key process indicator of the unhealthy industrial process of the plurality of industrial processes. The automation module 112 further causes the processing unit 202 to optimize the engineering project 106B by modifying the set of engineering objects associated with the unhealthy industrial process based on the determined plurality of modifications.

The automation module 112 further causes the processing unit 202 to capture an image of the piping and instrumentation diagram. The image is captured by the processing unit by use of an image capture device such as a camera in the wearable device 124. In another example, the image may be received by the processing unit 202 from a server or the like. The automation module 112 further causes the processing unit 202 to segment the captured image of the piping and instrumentation diagram into a plurality of portions. Each of the plurality of portions corresponds to at least one industrial process of the plurality of industrial processes.

The automation module 112 further causes the processing unit 202 to superpose information associated with the plurality of industrial processes associated with the engineering project 106B and the plurality of key process indicators associated with each of the determined plurality of industrial processes, on the captured image of the piping and instrumentation diagram. In one example, a specific industrial process and a specific Key process indicator associated with the specific industrial process is superposed upon a specific portion of the image, which corresponds to the specific industrial process and the specific Key process indicator.

The automation module 112 further causes the processing unit 202 to display the piping and instrumentation diagram and the information associated with the plurality of industrial processes associated with the engineering project 106B and the plurality of key process indicators associated with each of the determined plurality of industrial processes on an augmented reality based user interface.

The automation module 112 further causes the processing unit 202 to generate a simulation instance for the industrial environment 100. The automation module 112 further causes the processing unit 202 to simulate deployment of the optimized engineering project 106B in the industrial environment 100 by executing one or more functionalities of the engineering project 106B on the generated simulation instance.

The automation module 112 further causes the processing unit 202 to determine whether the optimized engineering project 106B is valid, based on a result of the simulated execution of the optimized engineering project 106B. The automation module 112 further causes the processing unit 202 to deploy the optimized engineering project 106B in real-time onto the industrial environment, based on a determination that the optimized engineering project 106B is valid. The automation module 112 further causes the processing unit 202 to display the engineering project 106B on a display device such as the wearable device 124.

The storage unit 206 may be a non-transitory storage medium configured for storing a database (such as database 118) which comprises server version of the one or more engineering object 108A-N associated with the engineering project 106B. The communication interface 208 is configured for establishing communication sessions between the one or more client devices 120A-N and the engineering system 102. The communication interface 208 allows the one or more engineering applications running on the client devices 120A-N to import/export engineering project files into the engineering system 102. In an embodiment, the communication interface 208 interacts with the interface at the one or more client devices 120A-N for allowing the engineers to access the engineering projects associated with an engineering project file and perform one or more actions on the engineering projects stored in the engineering system 102.

The input-output unit 210 may include input devices a keypad, touch-sensitive display, camera (such as a camera receiving gesture-based inputs), etc. capable of receiving one or more input signals, such as user commands to process engineering project file. Also, the input-output unit 210 may be a display unit for displaying a graphical user interface which visualizes the behavior model associated with the modified engineering projects and also displays the status information associated with each set of actions performed on the graphical user interface. The set of actions may include execution of predefined tests, download, compile and deploy of graphical programs. The bus 214 acts as interconnect between the processing unit 202, the memory 204, and the input-output unit 210.

The network interface 212 may be configured to handle network connectivity, bandwidth and network traffic between the engineering system 102, client devices 120A-N and the engineering project 106B.

Those of ordinary skilled in the art will appreciate that the hardware depicted in FIG 2 may vary for particular implementations. For example, other peripheral devices such as an optical disk drive and the like, Local Area Network (LAN), Wide Area Network (WAN), Wireless (e.g., Wi-Fi) adapter, graphics adapter, disk controller, input/output (I/O) adapter also may be used in addition or in place of the hardware depicted. The depicted example is provided for the purpose of explanation only and is not meant to imply architectural limitations with respect to the present disclosure.

Those skilled in the art will recognize that, for simplicity and clarity, the full structure and operation of all data processing systems suitable for use with the present disclosure is not being depicted or described herein. Instead, only so much of an engineering system 102 as is unique to the present disclosure or necessary for an understanding of the present disclosure is depicted and described. The remainder of the construction and operation of the engineering system 102 may conform to any of the various current implementation and practices known in the art.

FIG 3 is a block diagram of an automation module 112, such as those shown in FIG 2, in which an embodiment of the present invention can be implemented. In FIG 3, the automation module 112 comprises a request handler module 302, an object consistency checker module 304, an analysis module 306, a modifier module 308,an engineering project database 310, a validation module 312 and a deployment module 314. FIG. 3 is explained in conjunction with FIG. 1 and FIG. 2.

The request handler module 302 is configured for receiving the request to optimize the engineering project 106B. For example, the request is received from one of the one or more users external to the industrial environment 100 via a network. In alternative embodiment, the request is received from the one or the one or more client devices 120A-N via the network.

The object consistency checker module 304 is configured for determining a plurality of inconsistencies in the generated engineering project 106B.

In an embodiment, the object consistency checker module 304 is also configured for managing the one or more engineering objects 108A-N, physical connections between the plurality of devices represented by the one or more engineering objects 108A-N, and a plurality of parameter values associated with the one or more engineering objects 108A-N and the physical connections. In one example, each of the one or more engineering objects 108A-N comprises a set of programmable instructions or code statements corresponding to a program logic of each of the plurality of engineering projects. Each of the one or more engineering objects 108A-N may correspond to a function block under an engineering design. The engineering design may comprise several such function blocks. The users at the client devices 120A-N uses the engineering tool 122A-N in order to design or develop the plurality of engineering projects.

The analysis module 306 is configured for analyzing the ontology schema associated with the one or more engineering objects 108A-N. Specifically, the analysis module 306 is configured for retrieving data and control parameters associated with each of the one or more engineering objects 108A-N and the plurality of industrial processes. The data and control parameters are key process indicators comprising information relating to the set of programming blocks associated with the industrial domain of the engineering project 106B, for example, sensor data, actuator data, environment data, network data, any automation data and the like. Furthermore, the analysis module 306 is configured for analyzing the behavior of the one or more engineering objects 108A-N based on the generated ontology schema. In one example, the analysis module 306 is configured to analyze the engineering project 106B by application of a natural language processing algorithm on a source code of the engineering project 106B.

The modifier module 308 is configured for modifying the one or more engineering objects 108A-N based on the outcome of analysis of the ontology schema. The one or more engineering objects 108A-N is modified based on the analysis of the ontology schema. The modifications comprise any changes such as addition, deletion, update, replacement or revision of one or more variables, code lines, classes, functions, or comments in the one or more engineering objects 108A-N. Thus, the one or more engineering objects 108A-N are modified based on the relationships between the set of variables corresponding to teh plurality of Key process indicators associated with the plurality of industrial processes and the engineering project 106B. Thus, the plurality of engineering projects is generated based on the relationships between the set of variables corresponding to each logical block in the one or more engineering objects 108A-N, the set of Key process indicators associated with the one or more engineering objects 108A-N, and the industrial domain of the engineering project 106B.

The engineering project database 310 is configured for storing an engineering project library comprising a plurality of engineering projects and the generated ontology schema. The engineering project database 310 is furtehr configured to store information about the one or more engineering objects 108A-N, such as physical connections between the one or more engineering objects 108A-N, and a plurality of parameter values associated with the one or more engineering objects 108AN and the physical connections. The engineering project database 310 is configured for continuously updating the engineering project library with updated versions of the optimized engineering project 106B. Also, the engineering project database 310 is configured for maintaining the engineering project library in the generated ontology schema.

The validation module 312 is configured to generate a simulation instance for the industrial environment 100. In one example, the simulation instance is a digital twin of the one or more engineering objects 108A-N which are functioning in the industrial environment 100. The validation module 312 is configured to simulate execution of the optimized optimized engineering project 106B in the industrial environment 100 in a simulation environment by executing the generated first engineering object on the generated simulation instance.

The deployment module 314 is configured for deploying the optimized engineering project 106B onto the industrial environment 100 based on the validation. Advantageously, the optimized engineering project 106B is only deployed after the determination that the optimized engineering project 106B is valid.

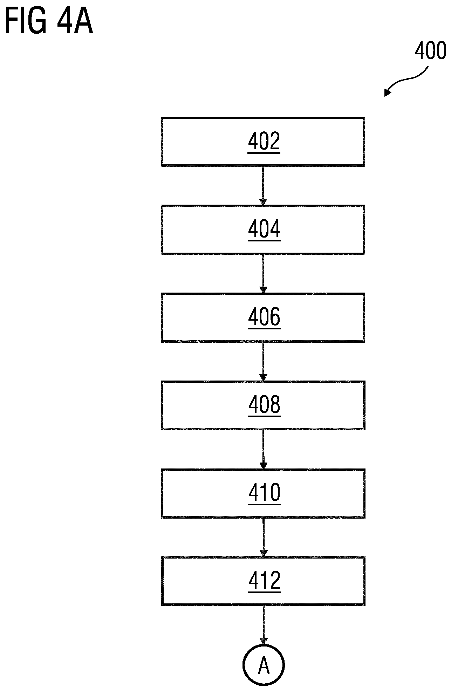

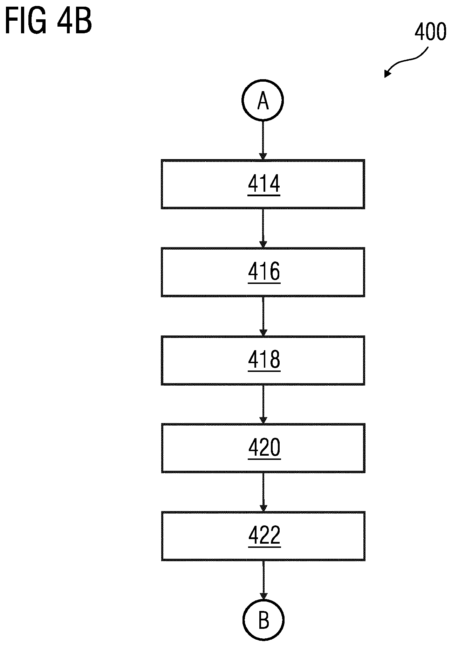

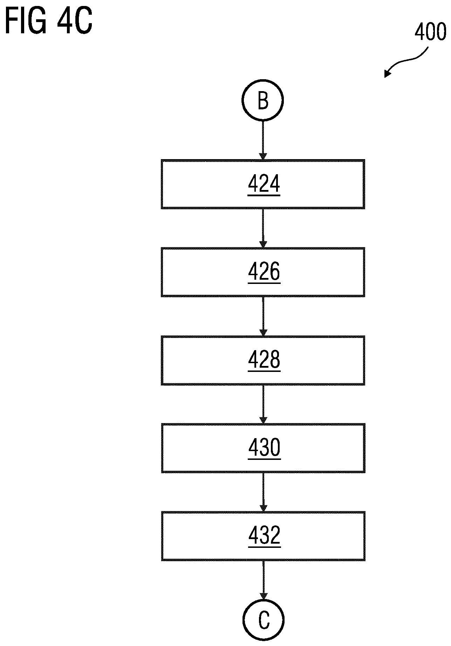

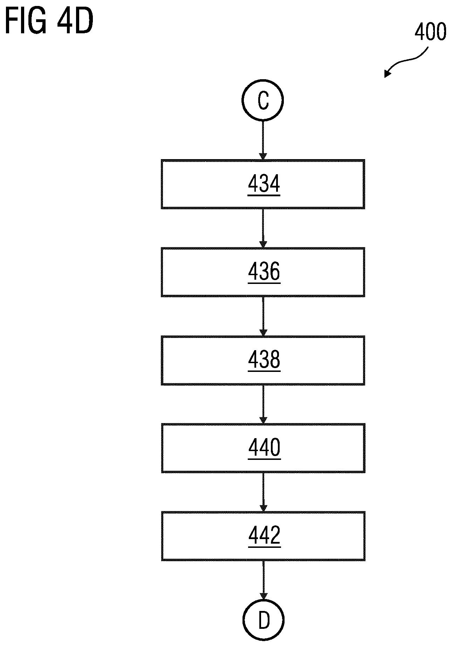

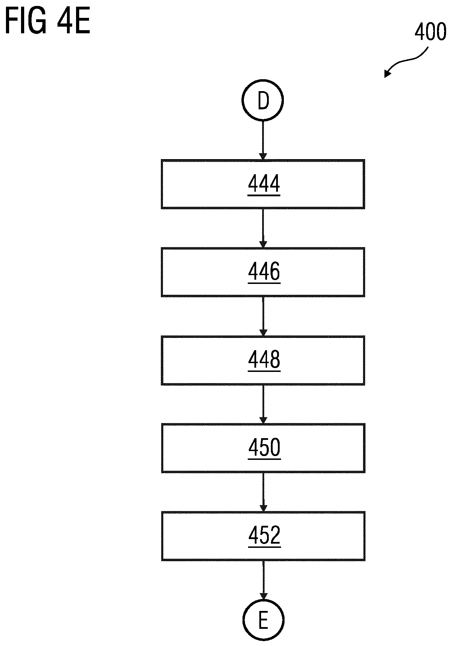

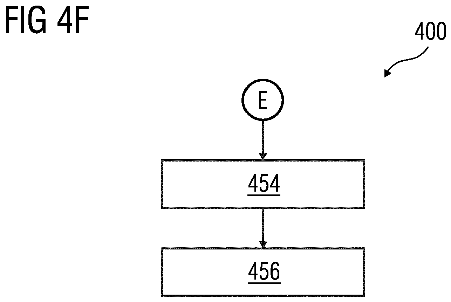

FIG 4A-F is a process flowchart illustrating an exemplary method 400 of generating engineering object with a specific specification from another engineering object in an engineering system 102, according to an embodiment of the present invention.

At step 402, a request to optimize the engineering project 106B in a technical installation 106A is received by the processing unit 202. The request comprises information about a piping and instrumentation diagram of the engineering project 106B. The request is received from a user as at least one of a gesture based, text based, or voice based input via an input device such as a microphone, a camera or a keyboard. The engineering project 106B comprises a plurality of engineering objects 108A-N. Each of the plurality of engineering objects comprises information and source code associated with a specific industrial process in a plurality of industrial processes of the engineering project 106B. Examples of the plurality of engineering objects comprises a design file, a program file, an openness file, an automation markup language (AML) file, a memory object, a description of a physical engineering equipment, and and a piping and instrumentation diagram of a technical installation. The plurality of industrial processes comprises chemical, biological, and thermodynamic processes occurring in the technical installation 106A.

At step 404, a natural language processing algorithm on information comprised in the engineering project 106B, is applied by the processing unit 202. In one example, the engineering project 106B comprises description of a plurality of parameter values, a blueprint, internal components, and internal interconnections between various internal components of the technical installation 106A. The description comprises text-based descriptions, figures, and blueprints of the engineering project 106B.

At step 406, a plurality of data items and a plurality of meta data items associated with the engineering project 106B is determined by the processing unit 202 based on the application of the natural language processing algorithm. Examples of the natural language processing algorithm includes but is not limited to Bayesian network algorithms and conditional random field algorithms. The plurality of data items comprises blueprints, descriptions about internal components of the second physical industrial equipment, code statements, data variables, variable assignment statements, looped statements comprised in the engineering project 106B. The plurality of metadata items comprises date of creation, author name, domain of an industrial environment in which the engineering project 106B is deployed. Each of the plurality of data items and the plurality of meta data items of the engineering project 106B may have data and control flow interrelationships with other data items and meta data items of the engineering project 106B.

At step 408, an ontology schema for the engineering project 106B is generated by the processing unit 202. The ontology schema comprises information about relationships between the piping and instrumentation diagram, and the plurality of engineering objectsv 108A-N of the engineering project 106B.

The ontology schema further comprises information associated with the interrelationships and dependencies between the plurality of data items and the plurality of metadata items of the engineering project 106B. The ontology schema is a digital twin of the engineering project 106B. In one example, the ontology schema is a knowledge graph based representation. The ontology schema is generated by an analysis of engineering project 106B. Advantageously, all interrelationships between the plurality of data items and the plurality of meta data items associated with the engineering project 106B is captured by the processing unit 202 automatically. Advantageously, a code developer is not required to manually extract and understand the plurality of data items and meta data items from the engineering project 106B, prior to modifying/optimizing the engineering project 106B. Thus, amount of time and labour of the code developer, invested to modify or optimize the engineering project 106B is diminished significantly.

At step 410, the plurality of industrial processes associated with the engineering project 106B and a plurality of key process indicators associated with each of the plurality of industrial processes is determined by the processing unit 202 based on an analysis of the ontology schema. The plurality of key process indicators comprises measurement data which indicate a progress of at least one industrial process of the plurality of industrial processes. Examples of the key process indicators comprises a temperature measurement, a pressure measurement and a vibration measurement.

At step 412, the determined plurality of industrial processes associated with the engineering project 106B and the plurality of key process indicators associated with each of the plurality of industrial processes is displayed on the wearable device 124 by the processing unit 202. The wearable device 124 is at least one of a handheld computing device or an augmented reality capable display device. Advantageously, a user is enabled to visualize the plurality of industrial processes and the plurality of key process indicators in the wearable device 124.

At step 414, a user selection of the at least one industrial process of the plurality of industrial processes and the at least one key process indicator of the plurality of key process indicators is received by the processing unit 202. The user selection may be received via an input device such as a keyboard, a computer mouse, a microphone, a touchscreen device or a camera. At step 416, the ontology schema is analyzed by the processing unit 202 to map the selected at least one industrial process and the selected at least one key process indicator to the one or more engineering objects 108A-N of the engineering project 106B. At step 418, the one or more engineering objects of the plurality of engineering objects, which is required to be modified to optimize the at least one key process indicator of the at least one industrial process based on the analysis of the ontology schema is determined by the processing unit 202. Advantageously, the one or more engineering objects 108A-N which are linked to the at least one industrial process and the at least one key process indicator is determined by the processing unit automatically. Advantageously, the code developer is not required to manually identify interdependencies between the plurality of engineering objects and the plurality of industrial processes.

At step 420, the engineering project 106B is optimized by the processing unit 202 by modifying one or more engineering objects 108A-N of the engineering project 106B, such that the at least one key process indicator of the at least one industrial process of the plurality of industrial processes is optimized. The one or more engineering objects 108A-N is one of a program file, an openness file, an automation markup language (AML) file, a memory object, a physical engineering equipment, and piping and instrumentation diagram.

At step 422, a plurality of modifications to be executed on the determined one or more engineering objects 108A-N, is determined by the processing unit 202 to optimize the at least one key process indicator of the at least one industrial process of the plurality of industrial processes. The modifications comprise any changes such as addition, deletion, update, replacement or revision of one or more variables, code lines, classes, functions, or comments in the one or more engineering objects 108A-N.

At step 424, the engineering project 106B is optimized by the processing unit 202 by modifying the one or more engineering objects 108A-N of the engineering project 106B based on the determined plurality of modifications.

At step 426, a plurality of process values associated with the plurality of industrial processes is received by the processing unit 202. The plurality of process values comprises a temperature value, a pressure value, a vibration value, and the like.

At step 428, a health level of each of the plurality of industrial processes is determined by the processing unit 202 based on an analysis of the ontology schema and the plurality of process values.

At step 430, a unhealthy industrial process from the plurality of industrial processes based on the determined health level of each of the plurality of industrial processes is determined by the processing unit 202. In one example, the health level of the plurality of industrial processes is determined based on an application of a machine learning algorithm on the plurality of process values. The machine learning algorithm is trained on historical data comprising the plurality of engineering projects and the plurality of industrial processes such that the machine learning algorithm is configured to determine the health level of the each of the plurality of industrial processes. Advantageously, the health level of the at least one industrial process is determined based on historical data.

At step 432, the ontology schema is analyzed by the processing unit 202 to map the unhealthy industrial process to a set of engineering objects of the engineering project 106B. At step 434, it is determined by the processing unit 202 that the set of engineering objects of the plurality of engineering objects, is required to be modified to optimize the unhealthy industrial process based on the analysis of the ontology schema. The modifications comprise any changes such as addition, deletion, update, replacement or revision of one or more variables, code lines, classes, functions, or comments in the one or more engineering objects 108A-N. At step 436, a plurality of modifications to be executed on the determined set of engineering objects, is determined by the processing unit 202 to optimize at least one key process indicator of the unhealthy industrial process of the plurality of industrial processes. At step 438, the engineering project 106B is optimized by the processing unit 202by modifying the set of engineering objects associated with the unhealthy industrial process based on the determined plurality of modifications.

At step 440, an image of the piping and instrumentation diagram. The image is captured by the processing unit 202 by use of an image capture device such as a camera in the wearable device 124. In another example, the image may be received by the processing unit 202 from a server or the like. At step 442, the captured image of the piping and instrumentation diagram into a plurality of portions is segmented by the processing unit 202. Each of the plurality of portions corresponds to at least one industrial process of the plurality of industrial processes.

At step 444, information associated with the plurality of industrial processes associated with the engineering project 106B and the plurality of key process indicators associated with each of the determined plurality of industrial processes, is superposed by the processing unit 202 on the captured image of the piping and instrumentation diagram. In one example, a specific industrial process and a specific Key process indicator associated with the specific industrial process is superposed upon a specific portion of the image, which corresponds to the specific industrial process and the specific Key process indicator.

At step 446, the piping and instrumentation diagram and the information associated with the plurality of industrial processes associated with the engineering project 106B and the plurality of key process indicators associated with each of the determined plurality of industrial processes is displayed by the processing unit 202 on an augmented reality based user interface.

At step 448, a simulation instance for the industrial environment 100 is generated by the processing unit 202. At step 450, deployment of the optimized engineering project 106B is simulated by the processing unit 202 in the industrial environment 100 by executing one or more functionalities of the engineering project 106B on the generated simulation instance.

At step 452, it is determined by the processing unit 202 whether the optimized engineering project 106B is valid, based on a result of the simulated execution of the optimized engineering project 106B.

At step 454, the optimized engineering project 106B is deployed by the processing unit 202 in real-time onto the industrial environment 100, based on a determination that the optimized engineering project 106B is valid.

At step 456, the engineering project 106B is displayed by the processing unit 202 on a display device such as the wearable device 124.

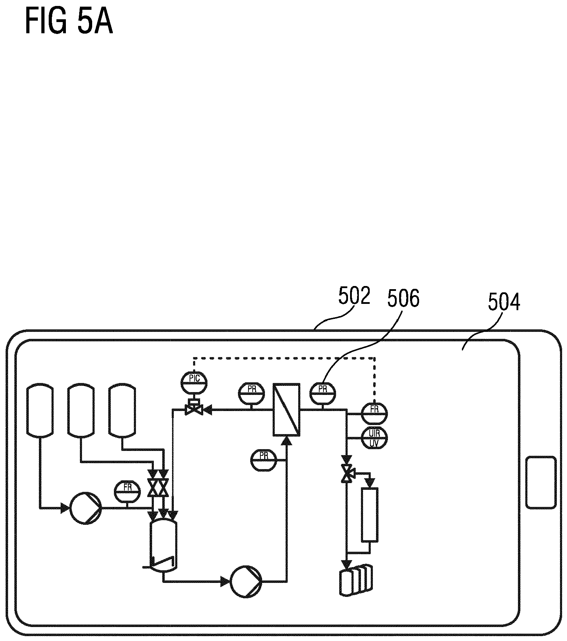

FIG 5A-B is a exemplary illustration of a working of the engineering system 102, according to an embodiment of the present invention. FIGs. 5A-B are described in conjunction with FIGs. 1, 2, 3, and 4a-e.

Referring to FIG. 5A, FIG. 5A illustrates a wearable device 502 (such as the wearable device 124 of FIG 1) which has a display screen 504. The display screen 504 is displaying a piping and instrumentation diagram 506.

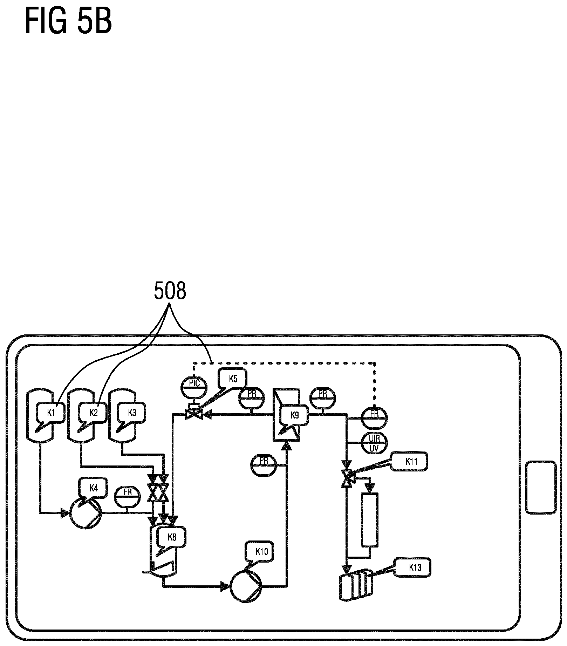

Referring to FIG. 5B, FIG. 5A illustrates the wearable device 502 which displays a plurality of labels 508 superposed on the piping and instrumentation diagram 506. The plurality of labels 508 comprise information about the plurality of industrial processes and a plurality of key process indicators of the engineering project 106B.

The present invention can take a form of a computer program product comprising program modules accessible from computer-usable or computer-readable medium storing program code for use by or in connection with one or more computers, processing units, or instruction execution system. For the purpose of this description, a computer-usable or computer-readable medium can be any apparatus that can contain, store, communicate, propagate, or transport the program for use by or in connection with the instruction execution system, apparatus, or device. The medium can be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processing units and program code for implementing each aspect of the technology can be centralized or distributed (or a combination thereof) as known to those skilled in the art.

While the present invention has been described in detail with reference to certain embodiments, it should be appreciated that the present invention is not limited to those embodiments. In view of the present disclosure, many modifications and variations would be present themselves, to those skilled in the art without departing from the scope of the various embodiments of the present invention, as described herein. The scope of the present invention is, therefore, indicated by the following claims rather than by the foregoing description. All changes, modifications, and variations coming within the meaning and range of equivalency of the claims are to be considered within their scope. All advantageous embodiments claimed in method claims may also be apply to system/apparatus claims.

### Reference sign list

- 1.: an industrial environment 100
- 2.: an engineering system 102
- 3.: one or more client devices 120A-N
- 4.: a network 104
- 5.: technical installation 106
- 6.: one or more engineering objects 108A-N
- 7.: a platform 110
- 8.: an automation module 112
- 9.: a server 114
- 10.: a network interface 116
- 11.: a database 118
- 12.: a processing unit 202
- 13.: an accessible memory 204
- 14.: a storage unit 206
- 15.: a communication interface 208
- 16.: an input-output unit 210
- 17.: a network interface 212
- 18.: a bus 214
- 19.: an integrated development environment (IDE) 216
- 20.: a request handler module 302,
- 21.: an object behavior model generation module 304,
- 22.: an analysis module 306,
- 23.: a modifier module 308
- 24.: an engineering object database 310
- 25.: a validation module 312
- 26.: a deployment module 314.
- 27.: A wearable device 502
- 28.: A display screen 504
- 29.: A piping and instrumentation diagram 506
- 30.: A plurality of labels 508

## Claims

1. A method for optimizing an engineering project (106B) in a technical installation (106A), the method comprising:
receiving, by a processing unit (202), a request to optimize an engineering project (106B) in a technical installation (106), wherein the request comprises information about a piping and instrumentation diagram (506) of the engineering project (106B);
generating, by the processing unit (202), an ontology schema for the engineering project (106B), wherein the ontology schema comprises information about relationships between the piping and instrumentation diagram (506), and a plurality of engineering objects of the engineering project (106B);
determining, by the processing unit (202), a plurality of industrial processes associated with the engineering project (106B) and a plurality of key process indicators associated with each of the plurality of industrial processes, based on an analysis of the ontology schema;
displaying on a wearable device (124), by the processing unit (202), the determined plurality of industrial processes associated with the engineering project (106B) and the plurality of key process indicators associated with each of the plurality of industrial processes;
receiving, by the processing unit (202), a user selection of at least one industrial process of the plurality of industrial processes and at least one key process indicator of the plurality of key process indicators; and
optimizing, by the processing unit (202), the engineering project (106B) by modifying one or more engineering objects (108A-N) of the engineering project (106B), such that the at least one key process indicator of the at least one industrial process of the plurality of industrial processes is optimized.

2. The method according to claim 1, wherein determining the one or more engineering objects (108A-N) of the plurality of engineering objects, which is required to be modified to optimize the at least one key process indicator of the at least one industrial process of the plurality of industrial processes of the engineering project (106B) comprises:
analyzing, by the processing unit (202), the ontology schema to map the selected at least one industrial process and the selected at least one key process indicator to the one or more engineering objects (108A-N) of the engineering project (106B); and
determining, by the processing unit (202), the one or more engineering objects (108A-N) of the plurality of engineering objects, which is required to be modified to optimize the at least one key process indicator of the at least one industrial process based on the analysis of the ontology schema.

3. The method according to claim 2, wherein optimizing the engineering project (106B) by modifying the one or more engineering objects (108A-N) of the engineering project (106B) further comprises:
determining, by the processing unit (202), a plurality of modifications to be executed on the determined one or more engineering objects (108A-N), to optimize the at least one key process indicator of the at least one industrial process of the plurality of industrial processes; and
optimizing, by the processing unit (202), engineering project (106B) by modifying the one or more engineering objects (108A-N) of the engineering project (106B) based on the determined plurality of modifications.

4. The method according to any one of claims 1 to 3, further comprising:
receiving, by the processing unit (202), a plurality of process values associated with the plurality of industrial processes;
determining, by the processing unit (202), a health level of each of the plurality of industrial processes based on an analysis of the ontology schema and the plurality of process values; and
determining, by the processing unit (202), an unhealthy industrial process from the plurality of industrial processes based on the determined health level of each of the plurality of industrial processes.

5. The method according to claim 4, further comprising:
analyzing, by the processing unit (202), the ontology schema to map the unhealthy industrial process to a set of engineering objects of the engineering project (106B); and
determining, by the processing unit (202), that the set of engineering objects of the plurality of engineering objects, is required to be modified to optimize the unhealthy industrial process based on the analysis of the ontology schema.

6. The method according to any one of claims 1 to 5, further comprising:
determining, by the processing unit (202), a plurality of modifications to be executed on the determined set of engineering objects, to optimize at least one key process indicator of the unhealthy industrial process of the plurality of industrial processes; and
optimizing, by the processing unit (202), the engineering project (106B) by modifying the set of engineering objects associated with the unhealthy industrial process based on the determined plurality of modifications.

7. The method according to any one of claims 1 to 6, wherein the wearable device (124) is at least one of a handheld computing device or an augmented reality capable display device.

8. The method according to any one of claims 1 to 7, wherein the one or more engineering objects (108A-N) is one of a program file, an openness file, an automation markup language (AML) file, a memory object, a physical engineering equipment, and piping and instrumentation diagram (506).

9. The method according to any one of claims 1 to 8, further comprising:
capturing, by the processing unit (202), an image of the piping and instrumentation diagram (506); and
superposing, by the processing unit (202), information associated with the plurality of industrial processes associated with the engineering project (106B) and the plurality of key process indicators associated with each of the determined plurality of industrial processes, on the captured image of the piping and instrumentation diagram (506).

10. The method according to claim 9, further comprising:
displaying, by the processing unit (202), the piping and instrumentation diagram (506) and the information associated with the plurality of industrial processes associated with the engineering project (106B) and the plurality of key process indicators associated with each of the determined plurality of industrial processes on an augmented reality based user interface.

11. The method according to any one of claims 1 to 10, further comprising:
generating, by the processing unit (202), a simulation instance for an industrial environment (100); and
simulating, by the processing unit (202), deployment of the optimized engineering project (106B) in the industrial environment by executing one or more functionalities of the engineering project (106B) on the generated simulation instance.

12. The method according to claim 11, further comprising:
determining, by the processing unit (202), whether the optimized engineering project (106B) is valid, based on a result of the simulated execution of the optimized engineering project (106B);
deploying, by the processing unit (202), the optimized engineering project (106B) in real-time onto the industrial environment, based on a determination that the optimized engineering project is valid; and
displaying, by the processing unit (202), the engineering project (106B) on one of a display device (120a-n) and the wearable device 124.

13. An engineering system for optimization of an engineering project (106B) in a technical installation, wherein the engineering system comprises:
one or more processing unit (202); and
a memory (204) coupled to the one or more processing unit(s), wherein the memory comprises an automation module stored in the form of machine-readable instructions executable by the one or more processing unit(s), wherein the automation module (112) is capable of performing a method according to any of the claims 1 to 12.

14. An industrial environment (100) comprising:
an engineering system (102) as claimed in claim 13;
a technical installation (106A) comprising one or more physical components; and
one or more client devices (120A-N) communicatively coupled to the engineering system (102) via a network (104), wherein the engineering system (102) is configured to perform a method according to any of the claims 1 to 12.

15. A computer-program product, having machine-readable instructions stored therein, that when executed by a processing unit (202), cause the processing units to perform a method according to any of the claims 1 to 12.
